# EUROPÄISCHE PATENTSCHRIFT

(11) **EP 1 535 372 B1**
(45) Veröffentlichungstag und Bekanntmachung des Hinweises auf die Patenterteilung: **18.10.2006**
(21) Anmeldenummer: 03793674.7
(22) Anmeldetag: 02.08.2003
(51) Int. Cl.: H01R 24/00, H01R 13/66, H05K 1/02

(54) **ELEKTRISCHE STECKBUCHSE**
ELECTRICAL SOCKET
FICHE FEMELLE ELECTRIQUE

(30) Priorität: 04.09.2002 DE 10242143
(43) Veröffentlichungstag der Anmeldung: 01.06.2005
(73) Patentinhaber: TELEGÄRTNER KARL GÄRTNER GMBH, 71144 Steinenbronn (DE)
(72) Erfinder: BEERWERTH, Wolfgang, 71144 Steinenbronn (DE); PHILIPP, Gerd, 71034 Böblingen (DE)
(74) Vertreter: Hoeger, Stellrecht & Partner Patentanwälte
(86) Internationale Anmeldenummer: PCT/EP2003/008577
(87) Internationale Veröffentlichungsnummer: WO 2004/023607

(56) Entgegenhaltungen:
- EP-A- 0 982 815
- DE-C- 19 649 668
- US-A- 5 310 363
- US-A- 5 326 284
- US-A- 5 414 393
- US-A- 5 432 484
- US-A- 5 435 752
- US-A- 5 647 767
- US-A- 5 700 167
- US-A- 6 089 923
- US-B1- 6 333 472

## Beschreibung

Die Erfindung betrifft eine elektrische Steckbuchse mit den Merkmalen des Oberbegriffs des Anspruchs 1.

Derartige Steckbuchsen sind auch unter der Bezeichnung "Western-Buchse" bekannt und werden in der Nachrichten- und Datentechnik vielfältig verwendet. Durch das Zusammenwirken der Steckbuchse mit einem korrespondierenden Verbindungsstecker kann eine lösbare elektrische Verbindung hergestellt werden zur Übertragung elektrischer Signale. Hierbei kommen zunehmend höhere Übertragungsraten zum Einsatz, wodurch die Gefahr besteht, daß sich innerhalb der Steckbuchse zwischen Leiterpaaren eine störende elektrische Signalankopplung einstellt, so daß die Übertragungsqualität beeinträchtigt wird. Die Signalankopplung ist sowohl kapazitiver als auch induktiver Natur.

Um derartige Kopplungen gering zu halten, wird in der US-A-5 186 647 sowie der US-A-5 362 257 vorgeschlagen, innerhalb des Kontaktmoduls bestimmte Leiter zu überkreuzen. Hierzu kommen aufwendig gestaltete Leiterführungen zum Einsatz, so daß die Herstellung der Steckbuchsen mit einem erheblichen Kostenaufwand verbunden ist.

In der DE 199 38 367 A1 wird eine Steckbuchse beschrieben, bei der acht Leiter nebeneinander angeordnet sind, wobei mittels einer am Kontaktmodul festlegbaren doppelseitig kaschierten Leiterplatte ein Kreuzungsbereich bereitgestellt wird, um die Leiter mit den Nummern 3 und 6 miteinander zu kreuzen. Hierzu müssen diese Leiter vor dem Aufbringen der doppelseitigen Leiterplatte unterbrochen werden, und die Leiterplatte muß in eine Aufnahme des Kontaktmoduls eingesetzt werden. Auch eine derartige Ausgestaltung der Steckbuchse ist somit mit beträchtlichen Herstellungskosten verbunden.

Aus der US-A-6,089,923 sowie der EP-A-0 982 815 sind elektrische Steckbuchsen bekannt, bei denen ein Gehäuse ein Kontaktmodul umgibt, das mehrere elektrische Leiter und Kontaktelemente umfaßt, wobei die Kontaktelemente von zugeordneten Steckkontakten eines Verbindungssteckers kontaktierbar sind. Jeweils zwei Leiter bilden ein Leiterpaar aus zur Übertragung eines hochfrequenten elektrischen Signals. Das Kontaktmodul weist eine mehrlagige elektrische Leiterplatte auf, in die die Kontaktelemente eingesetzt sind. Mit ihren über die Leiterplatte überstehenden, einem Steckerschacht zugewandten Endbereichen bilden die Kontaktelemente jeweils eine Kontaktfeder aus. Die Leiterplatte trägt Kompensationskondensatoren zur kapazitiven Kopplung von Leitern unterschiedlicher Leiterpaare. Die Leiterplatte trägt außerdem Leiterbahnen, die die elektrischen Leiter zumindest zweier Leiterpaare ausbilden. In einem ersten Leiterbahnabschnitt weist eine erste Leiterbahn des ersten Leiterpaares zu einer ersten Leiterbahn des zweiten Leiterpaares einen geringeren Abstand auf als zur zweiten Leiterbahn des zweiten Leiterpaares, und in einem zweiten Leiterbahnabschnitt weist die erste Leiterbahn des ersten Leiterpaares zur zweiten Leiterbahn des zweiten Leiterpaares einen geringeren Abstand auf als zur ersten Leiterbahn des zweiten Leiterpaares.

Aufgabe der vorliegenden erfindung ist es, eine elektrische Steckbuchse der eingangs genannten Art derart weiterzubilden, daß sie kostengünstig herstellbar ist und die Gefahr einer Signalankopplung zwischen unterschiedlichen Leiterpaaren vermindert ist.

Diese Aufgabe wird durch eine elektrische Steckbuchse mit den Merkmalen von Patentanspruch 1 gelöst.

Der Einsatz einer mehrlagigen elektrischen Leiterplatte in Kombination mit Kontaktelementen, die in die Leiterplatte eingesetzt sind und mit ihren freien Endbereichen Kontaktfedern ausbilden, ermöglicht eine kompakte Ausgestaltung des Kontaktmoduls. Durch das Einsetzen der Kontaktelemente in die Leiterplatte können die über die Leiterplatte überstehenden Endbereiche der Kontaktelemente in Form der Kontaktfedern sehr kurz gehalten werden, so daß einerseits eine federelastische Kontaktierung der zugeordneten Steckkontakte des Verbindungssteckers sichergestellt ist, daß aber andererseits induktive und kapazitive Kopplungen zwischen Leitern unterschiedlicher Leiterpaare gering gehalten werden können.

Das Einsetzen der Kontaktelemente in die Leiterplatte ermöglicht außerdem eine kostengünstige Herstellung der elektrischen Steckbuchse, da eine aufwendige Lötverbindung zwischen den Kontaktelementen und der Leiterplatte entfallen kann. Zusätzlich wird die Herstellung durch den Einsatz der mehrlagigen Leiterplatte vereinfacht. Unter einer mehrlagigen Leiterplatte wird hierbei eine Leiterplatte verstanden, die in mindestens zwei Ebenen elektrische Leiterbahnen aufweist, beispielsweise auf ihrer dem Steckerschacht zugewandten Oberseite und ihrer dem Steckerschacht abgewandten Unterseite. Derartige mehrlagige Leiterplatten sind dem Fachmann als sogenannte "Multi-Layer" bekannt.

Um einer kapazitiven Kopplung von Leitern unterschiedlicher Leiterpaare im Bereich der Kontaktelemente entgegenzuwirken, trägt die Leiterplatte Kompensationskondensatoren zur kapazitiven Kopplung von Leitern unterschiedlicher Leiterpaare. Mittels der Kompensationskondensatoren wird im Bereich der Leiterplatte eine kapazitive Gegenkopplung bereitgestellt, mit deren Hilfe die Signalankopplung zwischen unterschiedlichen Leiterpaaren vermindert werden kann.

Die erfindungsgemäße Steckbuchse weist außerdem Mittel zur induktiven Gegenkopplung auf. Hierzu ist der Verlauf der Leiterbahnen, die zumindest die Leiter zweier Leiterpaare ausbilden, derart gewählt, daß einer induktiven Kopplung im Bereich der Kontaktelemente und im Bereich eines ersten Leiterbahnabschnitts eine entsprechende induktive Kopplung in einem zweiten Leiterbahnabschnitt entgegenwirkt. Insgesamt kann dadurch die induktive Kopplung zwischen unterschiedlichen Leiterpaaren reduziert werden. Während in einem ersten Leiterbahnabschnitt eine erste Leiterbahn eines ersten Leiterpaares eine stärkere induktive Kopplung zu einer ersten Leiterbahn des zweiten Leiterpaares aufweist als zur zweiten Leiterbahn des zweiten Leiterpaares, ist die induktive Kopplung im zweiten Leiterbahnabschnitt gerade umgekehrt, d. h. im zweiten Leiterbahnabschnitt weist die erste Leiterbahn des ersten Leiterpaares eine stärkere induktive Kopplung zur zweiten Leiterbahn des zweiten Leiterpaares auf als zur ersten Leiterbahn des zweiten Leiterpaares.

Durch den kombinierten Einsatz von auf der Leiterplatte angeordneten Kompensationskondensatoren und einer Leiterbahnführung, die eine induktive Gegenkopplung ermöglicht, kann die Signalankopplung zwischen unterschiedlichen Leiterpaaren bei der erfindungsgemäßen elektrischen Steckbuchse sehr gering gehalten werden. Dies ermöglicht es, die erfindungsgemäß Steckbuchse auch zur Übertragung sehr hochfrequenter Signale zu verwenden.

Erfindungsgemäß weisen die Leiterbahnen des ersten und zweiten Leiterpaares einen derartigen Bahnverlauf auf, daß sie sich in einem gemeinsamen Schnittpunkt berührungslos überschneiden. Die vier Leiterbahnen, die das erste und zweite Leiterpaar ausbilden, werden also zu einem gemeinsamen Schnittpunkt zusammengeführt, in dem sie sich berührungslos überschneiden. Im Bereich des Schnittpunktes können die vier Leiterbahnen insgesamt einen sternförmigen Bahnverlauf ausbilden.

Von Vorteil ist es, wenn sich der erste Leiterbahnabschnitt unmittelbar an die Kontaktfedern anschließt.

Um eine besonders wirkungsvolle induktive Gegenkopplung zu erzielen, ist es günstig, wenn der erste Leiterbahnabschnitt kürzer ist als der zweite Leiterbahnabschnitt. Im ersten Leiterbahnabschnitt entspricht die räumliche Anordnung der Leiterbahnen im wesentlichen der Anordnung der Kontaktelemente, die von den zugeordneten Steckkontakten des Verbindungssteckers kontaktierbar sind. Eine induktive Kopplung zwischen Leitern unterschiedlicher Leiterpaare erfolgt sowohl im Bereich der Kontaktelemente als auch im Bereich des ersten Leiterbahnabschnittes. Um diese induktive Kopplung möglichst gering zu halten, ist es vorteilhaft, die Länge des ersten Leiterbahnabschnittes sehr gering zu wählen, während die Länge des zweiten Leiterbahnabschnittes, in dem eine induktive Gegenkopplung erfolgt, größer gewählt ist.

Eine kapazitive Kopplung zwischen Leitern unterschiedlicher Leiterpaare erfolgt nicht nur im Bereich der Kompensationskondensatoren und im Bereich der Kontaktelemente, sondern auch im Bereich der Leiterbahnen, wobei allerdings deren kapazitive Kopplung geringer ist als die kapazitive Kopplung, die mit der Kompensationskondensatoren erzielt wird. Es hat sich gezeigt, daß im Bereich der Leiterplatte eine besonders gute induktive und kapazitive Gegenkopplung erzielt werden kann, wenn die Leiterbahnen des ersten und zweiten Leiterpaares im zweiten Leiterbahnabschnitt bezogen auf den Querschnitt der mehrlagigen Leiterplatte an den Eckpunkten eines gleichseitigen Vierecks angeordnet sind.

Vorzugsweise ist die Leiterplatte vierlagig ausgestaltet, wobei die Leiterbahnen der ersten und zweiten Leiterpaare zumindest im zweiten Leiterbahnabschnitt jeweils in einer Ebene der Leiterplatte verlaufen. Bei einer derartigen Ausführungsform sind also die vier Leiterbahnen, die das erste und das zweite Leiterpaar ausbilden, zumindest im Bereich des zweiten Leiterbahnabschnittes jeweils in einer Ebene der vierlagigen Leiterplatte angeordnet.

Bei einer besonders bevorzugten Ausführungsform sind die Leiterbahnen des ersten und zweiten Leiterpaares im zweiten Leiterbahnabschnitt bezogen auf den Querschnitt der Leiterplatte an den Eckpunkten eines Quadrates angeordnet. Es hat sich überraschenderweise gezeigt, daß durch eine derartige Anordnung der Leiterbahnen im Bereich des zweiten Leiterbahnabschnittes die induktive und kapazitive Signalankopplung der elektrischen Steckbuchse besonders gering gehalten werden kann.

Um die erfindungsgemäße Anordnung der Leiterbahnen mit den voranstehend erläuterten unterschiedlichen Abständen in den ersten und zweiten Leiterbahnabschnitten auf konstruktiv einfache Weise zu erzielen, ist es günstig, wenn sich die Leiterbahnen Zumindest eines Leiterpaares zwischen dem ersten und zweiten Leiterbahnabschnitt berührungslos überschneiden.

Eine besonders geringe Signalankopplung zwischen Leitern unterschiedlicher Leiterpaare kann dadurch erzielt werden, daß sich die Leiterbahnen unter-schiedlicher Leiterpaare in einem einzigen Schnittpunkt berührungslos überschneiden. Der Bahnverlauf der Leiterbahnen wird bei einer derartigen Ausführungsform derart gewählt, daß die Leiterbahnen unterschiedlicher Leiterpaare lediglich einen einzigen Schnittpunkt aufweisen, während sich ansonsten allenfalls Leiterbahnen desselben Leiterpaares berührungslos überschneiden, ein weiterer Schnittpunkt von Leiterbahnen unterschiedlicher Leiterpaaren jedoch nicht vorliegt.

Vorzugsweise sind die Leiterbahnen in einem sich an den gemeinsamen Schnittpunkt anschließenden Bereich parallel zueinander ausgerichtet. Hierbei ist es von besonderem Vorteil, wenn sich die Leiterbahnen in diesem parallel ausgerichteten Bereich nicht überdecken, sondern versetzt zueinander angeordnet sind.

Wie bereits erläutert, sind bei der elektrischen Steckbuchse die Kontaktelemente in die Leiterplatte eingesetzt. Hierbei hat es sich als günstig erwiesen, wenn die Kontaktelemente in die Leiterplatte eingepresst sind.

Vorzugsweise durchgreifen die Kontaktelemente die Leiterplatte. Dadurch wird die mechanische Stabilität des Kontaktmodules verbessert. Außerdem ergibt sich dadurch die Möglichkeit, zumindest einige der Kontaktelemente auf der dem Steckerschacht abgewandten Unterseite der Leiterplatte mit weiterführenden Verbindungselementen zu verbinden, so daß diese Kontaktelemente im Bereich der Leiterplatte jeweils einen elektrischen Leiter ausbilden, der einstückig mit der zugeordneten Kontaktfeder verbunden ist.

Um den Kontaktelementen einerseits die erforderliche mechanische Stabilität zu verleihen und um andererseits sicherzustellen, daß die über die dem Steckerschacht zugewandte Oberseite der Leiterplatte überstehenden Endbereiche der Kontaktelemente selbst bei kurzer Federlänge keine dauerhafte Verformung zeigen, ist es von Vorteil, wenn zumindest einige der Kontaktelemente aus einem Federstahl gefertigt sind.

Wie bereits erläutert, können die Kontaktfedern sehr kurz gehalten werden. Als besonders vorteilhaft hat sich erwiesen, wenn die über die Oberseite der Leiterplatte überstehenden Endbereiche der Kontaktelemente, d. h. die Kontaktfedern, eine Länge von maximal 4 mm, vorzugsweise eine Länge von etwa 3 mm aufweisen.

Bei der erfindungsgemäßen elektrischen Steckbuchse trägt die Leiterplatte mehrere Kompensationskondensatoren. Hierbei hat es sich als besonders günstig erwiesen, wenn die Kompensationskondensatoren jeweils von zwei einander gegenüberliegenden, in unterschiedlichen Ebenen der mehrlagigen Leiterplatte angeordneten, elektrisch leitfähigen Schichtbereichen ausgebildet sind. Die Kompensationskondensatoren sind hierbei in Form von Plattenkondensatoren ausgestaltet, wobei die Kondensatorplatten jeweils von einem leitfähigen Schichtbereich der mehrlagigen Leiterplatte gebildet werden. Dies ermöglicht einen besonders kompakten Aufbau des Kontaktmoduls, wobei eine störende Signalankopplung sehr gering gehalten werden kann. Die Kapazität der Kompensationskondensatoren kann durch den Abstand der einander gegenüberliegenden elektrisch leitfähigen Schichtbereiche sowie durch die Größe der Schichtbereiche und die Dielektrizitätskonstante des Materials der Leiterplatte vorbestimmt werden.

Es hat sich gezeigt, daß eine besonders gute Übertragungsqualität erzielt werden kann, wenn die Kompensationskondensatoren in dem den Kontaktfedern unmittelbar benachbarten Bereich der Leiterplatte angeordnet sind.

Die Gefahr einer störenden Signalankopplung zwischen unterschiedlichen Leiterpaaren nimmt mit zunehmendem Abstand der Leiterpaare ab. Die Kopplung von einander unmittelbar benachbart angeordneten Leiterpaaren ist daher von besonderer Bedeutung. Bei einer bevorzugten Ausführungsform ist deshalb vorgesehen, daß jedes Leiterpaar über mindestens einen Kompensationskondensator mit dem unmittelbar benachbart angeordneten Leiterpaar gekoppelt ist. Mittels der Kompensationskondensatoren kann die störende kapazitive Kopplung der Leiterpaare zumindest teilweise kompensiert werden. Damit kann eine Signalankopplung bei den zum Einsatz kommenden Datenübertragungsraten durch entsprechende Dimensionierung der Kompensationskondensatoren gering gehalten werden.

Bei einer vorteilhaften Ausführungsform ist die Leiterplatte dreilagig ausgestaltet, d. h. die Leiterplatte trägt Leiterbahnen, die in drei im Abstand zueinander angeordneten Ebenen verlaufen. Besonders günstig ist es, wenn die Ebenen, in denen die Leiterbahnen angeordnet sind, in unterschiedlichem Abstand zueinander positioniert sind. So kann beispielsweise eine asymmetrisch ausgestaltete Leiterplatte zum Einsatz kommen dergestalt, daß die Leiterplatte auf ihrer Oberseite und auf ihrer Unterseite jeweils elektrische Leiterbahnen trägt und daß zusätzlich in einer Zwischenebene Leiterbahnen verlaufen, wobei die Zwischenebene unterschiedliche Abstände zur Oberseite und zur Unterseite aufweist.

Der Einsatz einer Leiterplatte mit mehreren in unterschiedlichem Abstand zueinander angeordneten Ebenen ermöglicht es insbesondere, für die einander berührungslos überschneidenden Leiterbahnen einen verhältnismäßig großen Abstand zu wählen, während der Abstand der elektrisch leitenden Schichtbereiche, die jeweils eine Kondensatorplatte ausbilden, geringer gewählt werden kann.

Im Falle einer dreilagigen Leiterplatte hat es sich als günstig erwiesen, wenn der Abstand der Zwischenebene zur Oberseite etwa ein Viertel bis ein Drittel der Gesamtdicke der Leiterplatte beträgt.

Wie bereits erläutert, kommt bei einer vorteilhaften Ausführungsform eine vierlagige Leiterplatte zum Einsatz. Hierbei ist es günstig, wenn die beiden mittleren Ebenen zueinander einen etwa doppelt so großen Abstand aufweisen wie zu der jeweils unmittelbar benachbarten äußeren Ebene, also der Ober- oder Unterseite der Leiterplatte.

Bei einer besonders bevorzugten Ausführungsform der elektrischen Steckbuchse trägt die Leiterplatte auf ihrer dem Steckerschacht abgewandten Unterseite mehrere Paare von Anschlußelementen, die jeweils einem Leiterpaar zugeordnet sind, wobei die Paare von Anschlußelementen im Abstand zueinander positioniert sind. Die Anschlußelemente können senkrecht zur Unterseite der Leiterplatte ausgerichtet sein, es kann aber auch eine schräge Ausrichtung, beispielsweise unter einem Winkel von 45° oder 60° zur Unterseite der Leiterplatte zum Einsatz kommen. Die zueinander beabstandeten Anschlußelemente vereinfachen den Anschluß von weiterführenden Verbindungselementen an die Leiterplatte. So kann beispielsweise vorgesehen sein, daß die Anschlußelemente jeweils einen Kontakt ausbilden. Die Anschlußelemente können hierbei einen größeren Abstand zueinander aufweisen als die auf der Vorderseite der Leiterplatte angeordneten Kontaktfedern.

Der Einsatz einer Leiterplatte mit oberseitig angeordneten Kontaktfedern und unterseitig angeordneten Anschlußelementen ermöglicht es insbesondere, das Kontaktmodul als Entkopplungselement auszugestalten, das sämtliche Bauteile zur induktiven und kapazitiven Gegenkopplung der Leiterpaare aufweist, also insbesondere Kompensationskondensatoren und Leiterbahnabschnitte mit vertauschten Abständen der Leiterbahnen unterschiedlicher Leiterpaare, so daß zusätzlich zum Kontaktmodul keine weiteren elektrischen Elemente eingesetzt werden müssen, um eine störende elektrische Signalankopplung zu kompensieren.

Bei einer besonders kostengünstig herstellbaren Ausführungsform sind die Anschlußelemente in die Leiterplatte eingesetzt, vorzugsweise eingepresst.

Vorteilhaft ist es, wenn die Anschlußelemente und die Kontaktelemente als in die Leiterplatte eingepresste Kontaktstifte ausgebildet sind, wobei einige Kontaktstifte über die dem Steckerschacht zugewandte Oberseite überstehen und die Kontaktfedern ausbilden und wobei einige Kontaktstifte über die dem Steckerschacht abgewandte Unterseite der Leiterplatte überstehen und Kontakte zum Anschluß von Verbindungselementen ausbilden. Die Kontaktstifte lassen sich beispielsweise in Form gestanzter Kontaktbänder in die mit Durchgangsbohrungen versehene Leiterplatte einpressen. Anschließend können überstehende Endbereiche der Kontaktstifte entweder abgetrennt werden, oder aber,sie werden im Bereich der Oberseite der Leiterplatte abgebogen und bilden Kontaktfedern aus, und im Bereich der Unterseite der Leiterplatte können überstehende Kontaktstifte Kontakte zum Anschluß von Verbindungselementen ausbilden. Der unterseitige Überstand der Kontaktstifte kann senkrecht zur Unterseite der Leiterplatte ausgerichtet sein, erforderlichenfalls kann der Überstand auch abgeschrägt werden, beispielsweise unter einem Winkel von 45° zur Unterseite der Leiterplatte. Dies gibt die Möglichkeit, elektrische Steckbuchsen mit unterschiedlicher Ausrichtung der Steckerschächte bezogen auf die Montageseite der Steckbuchsen zu fertigen, wobei für die Steckbuchsen Kontaktmodule zum Einsatz kommen können, die sich lediglich in der Ausrichtung der unterseitigen Überstände der Kontaktstifte unterscheiden, ansonsten aber einen identischen Aufbau aufweisen.

Vorzugsweise bilden die über die Oberseite der Leiterplatte überstehenden Kontaktstifte eine Kontaktanordnung mit acht nebeneinander angeordneten Kontaktfedern aus. Der Einsatz von acht nebeneinander angeordneten Kontaktfedern hat sich bei Fernsprechverbindungen bewährt. Aus Gründen der Wirtschaftlichkeit, der Zweckmäßigkeit und der Normierung wurde diese Ausgestaltung auch zur Übertragung von Daten mit höheren Datenübertragungsraten herangezogen, und es ist beabsichtigt derartig ausgestaltete Kontaktanordnungen auch bei Datenübertragungsraten von über 100 Mbit/s einzusetzen. Gemäß einem internationalen Standard (ANSI/EIA/TIA-578-1991) erfolgt die Zuordnung der einzelnen Kontaktfedern dergestalt, daß zu beiden Seiten der Kontaktanordnung jeweils die beiden äußeren Kontaktfedern einem Leiterpaar zugeordnet werden, daß die beiden mittigen Kontaktfedern der Kontaktanordnung einem weiteren Leiterpaar zugeordnet werden, und daß die jeweils zwischen zwei äußeren und den beiden mittigen Kontaktfedern angeordneten Kontaktfedern einem weiteren Leiterpaar zugeordnet werden zur Übertragung eines hochfrequenten elektrischen Signals.

Die über die Unterseite der Leiterplatte überstehenden Kontaktstifte bilden vorzugsweise eine Anschlußanordnung aus mit vier zueinander beabstandeten Paaren von Kontakten, an die zum Beispiel weiterführende Verbindungselemente angelötet werden können. Die vier Paare können hierbei an den Eckpunkten eines Rechteckes angeordnet sein, so daß sie sehr gut zugänglich sind zum Anschließen der Leiterplatte an weiterführende Verbindüngselemente, beispielsweise an weitere Leiterplatten oder auch an Anschlußleitungen. Durch den großen räumlichen Abstand der Kontaktpaare werden gegenseitige parasitäre Kopplungen weitgehend vermieden.

Die nachfolgende Beschreibung bevorzugter Ausführungsformen der Erfindung dient im Zusammenhang mit der Zeichnung der näheren Erläuterung. Es zeigen:
- Figur 1:: eine perspektivische Darstellung einer erfindungsgemäßen elektrischen Steckbuchse gemäß einer ersten Ausführungsform;
- Figur 2:: eine Schnittansicht der elektrischen Steckbuchse aus Figur 1;
- Figur 3:: eine Ansicht schräg von oben auf ein Kontaktmodul der Steckbuchse aus Figur 1;
- Figur 4:: eine Ansicht schräg von unten auf das Kontaktmodul der Steckbuchse aus Figur 1;
- Figur 5:: eine Teilschnittansicht einer Leiterplatte eines Kontaktmoduls;
- Figur 6:: eine Darstellung der Anordnung der Leiterbahnen der Leiterplatte aus Figur 5;
- Figur 7:: eine Schnittansicht eine erfindungsgemäßen Ausführungsform einer Leiterplatte des Kontaktmoduls längs der Linie 7-7 in Figur 8;
- Figur 8:: eine Darstellung der Anordnung der Leiterbahnen der Leiterplatte aus Figur 7;
- Figur 9:: eine perspektivische Darstellung einer erfindungsgemäßen elektrischen Steckbuchse gemäß einer weiteren Ausführungsform und
- Figur 10:: eine Schnittansicht der elektrischen Steckbuchse aus Figur 9.

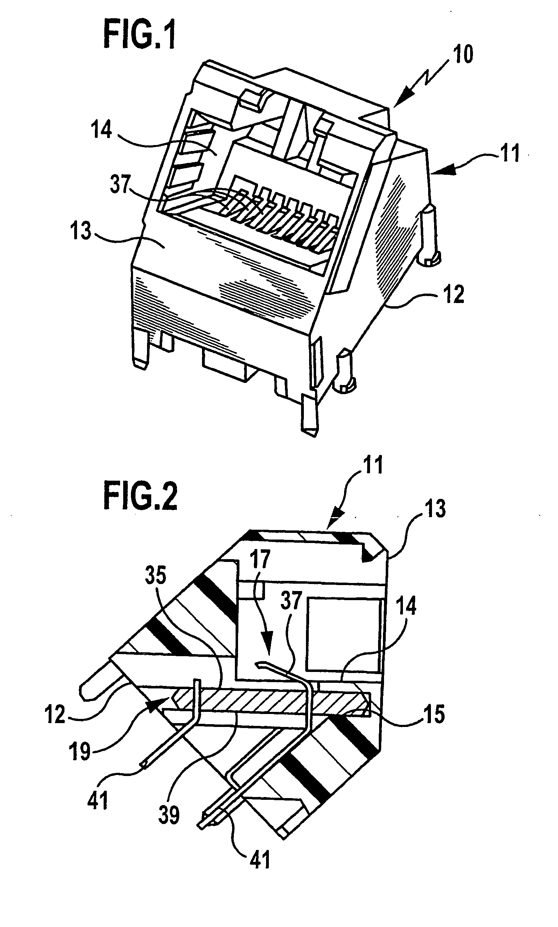

In den Figuren 1 bis 6 ist schematisch eine erste Ausführungsform einer insgesamt mit dem Bezugszeichen 10 belegten, modulartig aufgebauten elektrischen Steckbuchse dargestellt mit einem Gehäuse 11, das eine unter einem Winkel von 45° zu einer Montageseite 12 ausgerichtete Frontseite 13 aufweist, in die in üblicher Weise ein Steckerschacht 14 einmündet zur Aufnahme eines der Steckbuchse 10 zugeordneten elektrischen Verbindungssteckers. Derartige Verbindungsstecker sind bekannt und deshalb in der Zeichnung nicht dargestellt. Auf der Montageseite 12 sind an das Gehäuse 11 mehrere Rastelemente angeformt, mit deren Hilfe die Steckbuchse 10 auf einen Träger aufgerastet werden kann.

Das Gehäuse 11 umfaßt einen Montageschacht 15, der in die Montageseite 12 einmündet und in den ein Kontaktmodul 17 eingesetzt ist.

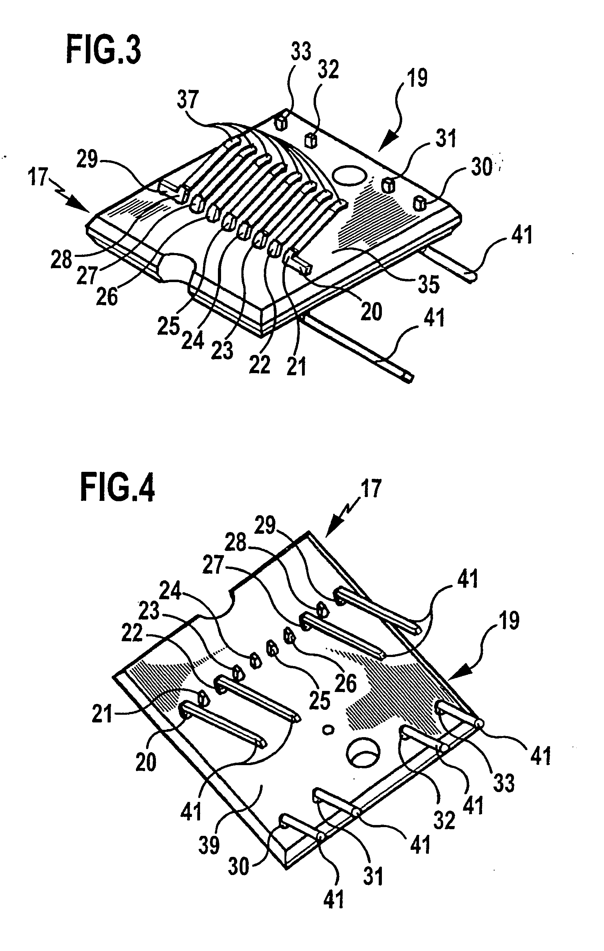

Wie insbesondere aus den Figuren 3 und 4 deutlich wird, umfaßt das Kontaktmodul 17 eine Leiterplatte 19. In nachfolgend näher erläuterte Durchgangsbohrungen der Leiterplatte 19 sind insgesamt 14 Kontaktstifte 20 bis 33 eingepresst, die jeweils die Leiterplatte 19 durchgreifen. Die Kontaktstifte 20 bis 29 sind in einer Reihe nebeneinander angeordnet, wobei acht Kontaktstifte, nämlich die Kontaktstifte 21 bis 28, über die dem Steckerschacht 14 zugewandte Oberseite 35 der Leiterplatte 19 hinausragen und Kontaktelemente ausbilden mit überstehenden Endbereichen in Form schräg zur Oberseite 35 ausgerichteter Kontaktfedern 37, die jeweils von einem zugeordneten Steckkontakt des in der Zeichnung nicht dargestellten Verbindungssteckers kontaktierbar sind, wenn der Verbindungsstecker in den Steckerschacht eingeführt wird.

Von den in einer Reihe nebeneinander angeordneten Kontaktstiften 20 bis 29 ragen die Kontaktstifte 20, 22 sowie 27 und 29 deutlich über die dem Steckerschacht 14 abgewandte Unterseite 39 der Leiterplatte 19 hinaus, und auch die Kontaktstifte 30, 31 und 32, 33 ragen deutlich über die Unterseite 39 hinaus. Mit ihren überstehenden Endbereichen bilden diese Kontaktstifte auf der Unterseite 39 der Leiterplatte 19 jeweils ein Anschlußelement mit einem Kontakt 41, an den z. B. ein weiterführendes Verbindungselement angelötet werden kann. Eine weitere Verbindungsmöglichkeit wäre beispielsweise das Einpressen der Kontakte 41 in eine Leiterplatte.

Die jeweils eine Kontaktfeder 37 ausbildenden Kontaktstifte 21 bis 28 sind aus Federstahl hergestellt, so daß die Kontaktfedern 37 federelastisch verbogen werden können bei der Kontaktierung des Verbindungssteckers. Die restlichen Kontaktstifte 20, 29 sowie 30 bis 33 können ebenfalls aus Federstahl oder aber aus einem anderen elektrisch-leitfähigen Material hergestellt sein.

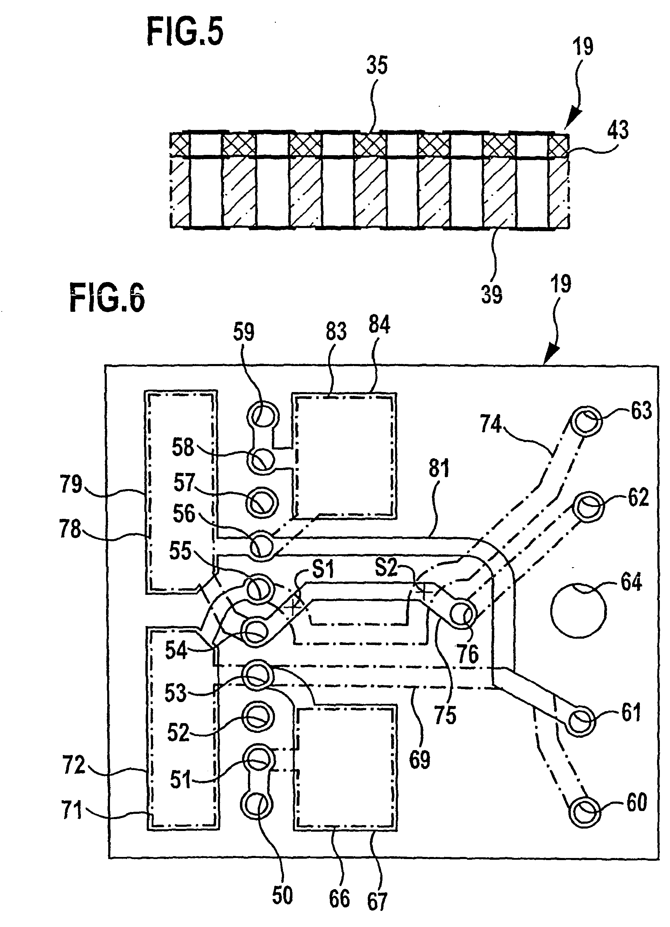

Die Leiterplatte 19 ist mehrlagig als sogenannter asymmetrischer Multi-Layer ausgestaltet. Dies wird insbesondere aus Figur 5 deutlich. Sie trägt auf ihrer Oberseite 35 sowie auf ihrer Unterseite 39 und zusätzlich in einer Zwischenschicht 43 elektrische Leiterbahnen. Der Abstand der Zwischenschicht 43 zur Oberseite 35 ist beträchtlich geringer als der Abstand, den die Zwischenschicht 43 zur Unterseite 39 aufweist, und zwar beträgt der Abstand zur Oberseite vorzugsweise etwa 0,36 mm, während der Abstand zur Unterseite ca. 1,14 mm beträgt. Die Gesamtstärke der Leiterplatte 19 beläuft sich folglich auf etwa 1,5 mm.

Der Verlauf der Leiterbahnen der Leiterplatte 19 wird aus dem in Figur 6 dargestellten Layout deutlich. In Figur 6 sind Leiterbahnen, die entlang der Oberseite 35 der Leiterplatte 19 verlaufen, in durchgezogener Linie dargestellt, während Leiterbahnen, die in der Zwischenschicht 43 oder entlang der Unterseite 39 verlaufen, in Figur 6 strichpunktiert dargestellt sind. Die Leiterplatte 19 weist in einer Reihe nebeneinander angeordnete Durchgangsbohrungen 50 bis 59 auf, die jeweils einen Kontaktstift 20 bis 29 aufnehmen. Zusätzlich umfaßt die Leiterplatte 19 Durchgangsbohrungen 60 bis 63, die die Kontaktstifte 30 bis 33 aufnehmen. Sämtliche Durchgangsbohrungen 50 bis 63 sind jeweils mit in der Zeichnung nicht dargestellten, an sich bekannten elektrisch leitfähigen Hülsen versehen, die wiederum die Kontaktstifte 20 bis 33 aufnehmen. Außerdem weist die Leiterplatte 19 eine durchgehende Lagesicherungsbohrung 64 auf.

Die Durchgangsbohrung 50 ist über eine auf der Oberseite 35 der Leiterplatte 19 angeordnete Leiterbahn mit der benachbarten Durchgangsbohrung 51 verbunden, von der sich innerhalb der Zwischenschicht 43 eine Leiterbahn zu einem in der Zwischenschicht 43 angeordneten elektrisch leitfähigen Schichtbereich in Form eines Kondensatorfeldes 66 erstreckt. Oberhalb des rechteckig ausgestalteten Kondensatorfeldes 66 ist auf der Oberseite 35 der Leiterplatte 19 ein entsprechend ausgebildeter Schichtbereich in Form eines Kondensatorfeldes 67 angeordnet, das über eine Leiterbahn mit der Durchgangsbohrung 53 in Verbindung steht. Die beiden Kondensatorfelder 66 und 67 bilden einen Kompensationskondensator.

Von der Durchgangsbohrung 53 verläuft auf der Unterseite 39 der Leiterplatte 19 eine Leiterbahn 69 zur Durchgangsbohrung 60, außerdem ist die Durchgangsbohrung 53 mit einem in der Zwischenschicht 43 angeordneten Kondensatorfeld 71 elektrisch verbunden. Dem Kondensatorfeld 71 ist ein auf der Oberseite 35 angeordnetes Kondensatorfeld 72 zugeordnet, das mit der Durchgangsbohrung 55 über eine Leiterbahn verbunden ist.

Von der Durchgangsbohrung 55 erstreckt sich auf der Unterseite 39 eine Leiterbahn 74, über die die Durchgangsbohrung 55 mit der Durchgangsbohrung 63 in elektrischer Verbindung steht. Die Leiterbahn 74 wird zweimal von einer Leiterbahn 75 überschnitten, die eine Verbindung herstellt zwischen der Durchgangsbohrung 54 und der Durchgangsbohrung 62. Die Leiterbahn 75 verläuft in einem ersten Teilstück auf der Oberseite 35, während ein zweites Teilstück auf der Unterseite 39 angeordnet ist, das über eine Kontaktierung 76 mit dem ersten Teilstück verbunden ist. Die Durchgangsbohrung 54 ist zusätzlich über eine Leiterbahn mit einem in der Zwischenschicht 43 angeordneten Kondensatorfeld 78 verbunden, dem auf der Oberseite 35 der Leiterplatte 19 ein entsprechendes Kondensatorfeld 79 zugeordnet ist, welches mit der Durchgangsbohrung 56 in elektrischer Verbindung steht. Die Durchgangsbohrung 56 ist über eine Leiterbahn 81 mit der Durchgangsbohrung 61 verbunden. Die Leiterbahn 81 läuft auf der Oberseite 35 der Leiterplatte 19 und überschneidet die unterseitig angeordneten Leiterbahnen 74 und 69 sowie das ebenfalls auf der Unterseite 39 der Leiterplatte 19 angeordnete zweite Teilstück der Leiterbahn 75.

Die Durchgangsbohrung 56 steht außerdem mit einem Kondensatorfeld 83 in elektrischer Verbindung, das in der Zwischenschicht 43 angeordnet ist und dem ein Kondensatorfeld 84 auf der Oberseite 35 zugeordnet ist, das mit der Durchgangsbohrung 58 verbunden ist. Die Durchgangsbohrung 58 ist zusätzlich über eine Leiterbahn mit der Durchgangsbohrung 59 verbunden.

Wie bereits erläutert, bilden die übereinander angeordneten Kondensatorfelder 66, 67 ebenso wie die Kondensatorfelder 71, 72 und 78, 79 sowie 83, 84 jeweils einen Kompensationskondensator, mit dessen Hilfe störende kapazitive Kopplungen zwischen den Kontaktfedern 37 kompensiert werden können.

Die beiden in der Reihe der Durchgangsbohrungen 50 bis 59 mittig angeordneten Durchgangsbohrungen 54 und 55 sind entsprechend dem bereits genannten internationalen Standard einem ersten Leiterpaar zur Übertragung hochfrequenter elektrischer Signale zugeordnet. Die unmittelbar benachbart angeordneten Durchgangsbohrungen 53 und 56 sind einem zweiten Leiterpaar zugeordnet, und die beiden jeweils außenliegenden Durchgangsbohrungen 51, 52 sowie 57, 58 sind jeweils einem weiteren Leiterpaar zugeordnet. Demzufolge ist das den Durchgangsbohrungen 57 und 58 entsprechende Leiterpaar über den von den Kondensatorfeldern 83 und 84 gebildeten Kompensationskondensator mit dem Leiterpaar gekoppelt, das den Durchgangsbohrungen 53 und 56 zugeordnet ist. Mit dem zuletzt genannten Leiterpaar ist über den von den Kondensatorfeldern 66 und 67 ausgebildeten Kompensationskondensator auch das den Durchgangsbohrungen 51 und 52 entsprechende Leiterpaar gekoppelt. Zur Berücksichtigung der kapazitiven Kopplung zwischen dem den Durchgangsbohrungen 53 und 56 entsprechenden Leiterpaar und dem den beiden mittigen Durchgangsbohrungen 54 und 55 entsprechenden Leiterpaar kommen die Kompensationskondensatoren zum Einsatz, die von den Kondensatorfeldern 71 und 72 bzw. 78, 79 gebildet werden.

Wie bereits erwähnt, wird die Leiterbahn 74 zweimal von der Leiterbahn 75 überschnitten, und zwar in einem ersten Schnittpunkt S1, der den Durchgangsbohrungen 54, 55 unmittelbar benachbart angeordnet ist, und in einem zweiten Schnittpunkt S2, der im Abstand zum ersten Schnittpunkt S1 positioniert ist. Die Leiterbahnen 74 und 75 bilden ein erstes Leiterpaar, das die Durchgangsbohrungen 54, 55, die die Kontaktstifte 24 bzw. 25 aufnehmen, mit den Durchgangsbohrungen 62 und 63 verbindet, in die die Kontaktstifte 32 bzw. 33 eingesetzt sind. Die unmittelbar benachbart angeordneten Leiterbahnen 69 und 81 bilden ein zweites Leiterpaar, über das die Durchgangsbohrungen 53 und 56 mit den Durchgangsbohrungen 60 bzw. 61 in Verbindung stehen. Durch das Überschneiden der Leiterbahnen 74 und 75 im Schnittpunkt S1 ändert sich die Relativlage dieser beiden Leiterbahnen zu den benachbarten Leiterbahnen 69 und 81 dergestalt, daß die Leiterbahn 74 in einem ersten Leiterbahnabschnitt, der sich zwischen der Durchgangsbohrung 55 und dem Schnittpunkt S1 erstreckt, einen geringeren Abstand zur Leiterbahn 81 als zur Leiterbahn 69 aufweist, während in einem zweiten Leiterbahnabschnitt, der sich vom Schnittpunkt S1 bis zum Schnittpunkt S2 erstreckt, der Abstand der Leiterbahn 74 zur Leiterbahn 69 geringer ist als zur Leiterbahn 81. Entsprechendes gilt für die Leiterbahn 75, die im ersten Leiterbahnabschnitt, also im Bereich zwischen der Durchgangsbohrung 54 und dem Schnittpunkt S1, einen geringeren Abstand zur Leiterbahn 69 als zur Leiterbahn 81 aufweist, während sie im zweiten Leiterbahnabschnitt, d. h. zwischen den beiden Schnittpunkten S1 und S2, einen geringeren Abstand zur Leiterbahn 81 als zur Leiterbahn 69 aufweist. Da die induktive Kopplung.zwischen den Leiterpaaren 74, 75 und 69, 81 vom Abstand abhängig ist, den die Leiterbahnen 74, 75, die ein erstes Leiterpaar ausbilden, zu den Leiterbahnen 69, 81 aufweisen, die ein zweites Leiterpaar ausbilden, wird durch die vertauschte Anordnung der beiden Leiterbahnen 74, 75 im zweiten Leiterbahnabschnitt verglichen mit der Anordnung, die sie im ersten Leiterbahnabschnitt einnehmen, eine induktive Gegenkopplung dergestalt erzielt, daß die im Bereich der Kontaktstifte 24, 25 und im Bereich des ersten Leiterbahnabschnittes auftretende induktive Kopplung der Leiter des ersten Leiterpaares 74, 75 zu den Leitern des zweiten Leiterpaares 69, 81 durch eine induktive Gegenkopplung im Bereich des zweiten Leiterbahnabschnittes weitgehend kompensiert wird.

Der Abgriff der elektrischen Signale, die der Steckbuchse 10 über den in der Zeichnung nicht dargestellten Verbindungsstecker zugeführt werden, erfolgt von der Unterseite 39 der Leiterplatte 19. Hierbei bilden jeweils zwei unmittelbar benachbart zueinander angeordnete Kontakte 41 ein Anschlußpaar, das einem der voranstehend genannten Leiterpaare zugeordnet ist. Die Anschlußpaare sind im Abstand zueinander an den Eckpunkten eines Rechteckes angeordnet. Dies wird insbesondere aus Figur 4 deutlich. Aus den Figuren 3 und 4 ist auch ersichtlich, daß der gegenseitige Abstand der jeweils einen Steckkontakt des Verbindungssteckers kontaktierenden Kontaktfedern 37 verhältnismäßig gering bemessen ist, während der Abstand der Kontakte 41 größer gewählt ist, so daß die Kontakte 41 zum Anschluß weiterführender Verbindungselemente gut zugänglich sind.

Aus dem Voranstehenden wird deutlich, daß das Kontaktmodul 17 mit der Leiterplatte 19 und den Kontaktstiften 20 bis 33 ein induktives und kapazitives Entkopplungselement ausbildet, das vom Verbindungsstecker kontaktierbar ist und auf seiner dem Steckerschacht 14 abgewandten Unterseite paarweise angeordnete Kontakte 41 trägt, wobei jeweils ein Kontaktpaar einem Leiterpaar zur Übertragung hochfrequenter elektrischer Signale entspricht.

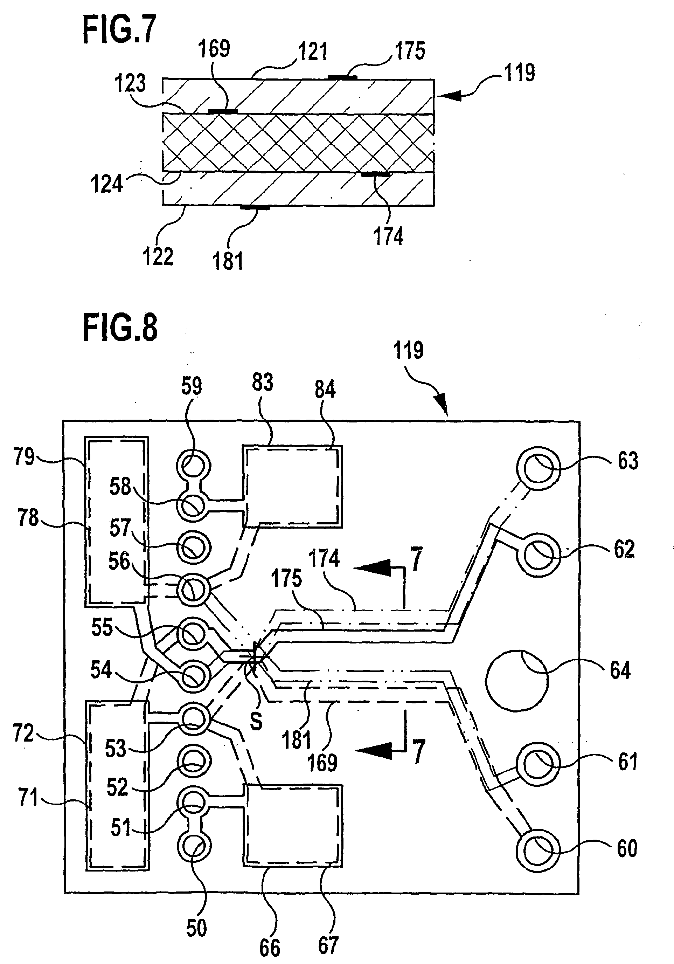

In den Figuren 7 und 8 ist eine erfindungsgemäße Ausführungsform einer insgesamt mit dem Bezugszeichen 119 belegten Leiterplatte dargestellt. Diese ist ähnlich ausgestaltet wie die Leiterplatte 19. Für identische oder gleichwirkende Bauteile werden daher in Figur 8 dieselben Bezugszeichen verwendet wie in Figur 6 und bezüglich dieser Bauteile wird zur Vermeidung von Wiederholungen vollinhaltlich auf die voranstehenden Erläuterungen Bezug genommen.

Die Leiterplatte 119 ist vierlagig ausgebildet und umfaßt eine Oberschicht 121, eine Unterschicht 122 sowie eine obere Zwischenschicht 123 und eine untere Zwischenschicht 124. Der Abstand der beiden Zwischenschichten 123, 124 zueinander ist hierbei etwa doppelt so groß wie der Abstand, den die Zwischenschichten 123, 124 zur jeweils unmittelbar benachbarten Ober- bzw. Unterschicht 121, 122 aufweisen. So beträgt der Abstand zwischen den beiden Zwischenschichten vorzugsweise ca. 0,71 mm, während der Abstand einer jeder Zwischenschicht 123, 124 zur jeweils unmittelbar benachbarten Ober- bzw. Unterschicht ca. 0,36 mm beträgt.

Die Leiterplatte 119 weist ebenfalls die voranstehend unter Bezugnahme auf die Figur 6 bereits erläuterten Durchgangsbohrungen 50 bis 59 auf, die in Reihe nebeneinander angeordnet sind und jeweils einen Kontaktstift 20 bis 29 aufnehmen. Außerdem umfaßt auch die Leiterplatte 119 Durchgangsbohrungen 60 bis 63, die die Kontaktstifte 30 bis 33 aufnehmen. Wiederum sind die Durchgangsbohrungen 50 bis 63 jeweils mit in der Zeichnung nicht dargestellten Hülsen versehen, die wiederum die genannten Kontaktstifte 20 bis 33 aufnehmen. Auch bei der Leiterplatte 119 kommt eine durchgehende Lagesicherungsbohrung 64 zum Einsatz.

Die Leiterplatte 119 trägt ebenfalls die unter Bezugnahme auf Figur 6 bereits im einzelnen erläuterten Kontaktfelder 66, 67 sowie 71, 72 und 78, 79 sowie 83, 84, die jeweils einen Kompensationskondensator zur kapazitiven Gegenkopplung ausbilden. Die Kondensatorfelder 66, 72, 79 und 83 sind auf der Oberschicht 121 der vierlagigen Leiterplatte 119 angeordnet, während die jeweils zugeordneten Kondensatorfelder 67, 71, 78 und 84 auf der oberen Zwischenschicht 123 angeordnet sind. Die elektrische Verbindung der Kondensatorfelder mit den jeweiligen Durchgangsbohrungen ist identisch mit den entsprechenden Verbindungen bei der Leiterplatte 19. Zur Vermeidung von Wiederholungen wird diesbezüglich auf die voranstehenden Ausführungen Bezug genommen.

Von der Leiterplatte 19 unterscheidet sich die Leiterplatte 119 im wesentlichen dadurch, daß die Leiterbahnen, über die die Durchgangsbohrungen 53, 54, 55 und 56 mit den Durchgangsbohrungen 60, 63, 62 bzw. 61 in elektrischer Verbindung stehen, einen anderen Bahnverlauf aufweisen. In Figur 8 sind die auf der Oberschicht 121 verlaufenden Leiterbahnen in durchgezogener Linie dargestellt, die auf der oberen Zwischenschicht 123 verlaufenden Leiterbahnen sind gestrichelt dargestellt, die auf der unteren Zwischenschicht 124 verlaufenden Leiterbahnen sind strichpunktiert dargestellt, und die auf der Unterschicht 122 verlaufenden Leiterbahnen sind strichdoppelpunktiert dargestellt. Die Durchgangsbohrung 53 steht über eine Leiterbahn 169 mit der Durchgangsbohrung 60 in elektrischer Verbindung, und die Durchgangsbohrung 56 ist über eine Leiterbahn 181 mit der Durchgangsbohrung 61 verbunden. Diese beiden Leiterbahnen 169 und 181 bilden in entsprechender Weise, wie dies bereits voranstehend unter Bezugnahme auf die Figur 6 im Zusammenhang mit den Leiterbahnen 69 und 81 erläutert wurde, ein Leiterpaar zur Übertragung eines hochfrequenten elektrischen Signals.

Die Durchgangsbohrung 54 steht über eine Leiterbahn 174 mit der Durchgangsbohrung 63 in elektrischer Verbindung, und die Durchgangsbohrung 55 ist über eine Leiterbahn 175 mit der Durchgangsbohrung 62 verbunden. Die Leiterbahnen 174 und 175 bilden ebenfalls ein Leiterpaar zur Übertragung eines hochfrequenten elektrischen Signals. Die Leiterbahnen 169, 181, 174, 175 verlaufen jeweils in einer Ebene der Leiterplatte 119, und zwar verläuft die Leiterbahn 169 auf der oberen Zwischenschicht 123, die Leiterbahn 181 verläuft auf der Unterschicht 122, die Leiterbahn 174 verläuft auf der unteren Zwischenschicht 124, und die Leiterbahn 175 verläuft auf der Oberschicht 121. Dies wird insbesondere aus Figur 7 deutlich.

Wie aus Figur 8 ersichtlich ist, sind die Leiterbahnen 169, 181, 174 und 175 ausgehend von den jeweiligen Durchgangsbohrungen 53, 56, 54 bzw. 55 zu einem einzigen gemeinsamen Schnittpunkt S zusammengeführt, in dem sie sich berührungslos überschneiden. Der kurze Bereich zwischen den jeweiligen Durchgangsbohrungen und dem Schnittpunkt S bildet einen ersten Leiterbahnabschnitt. An den Schnittpunkt S schließt sich ein zweiter Leiterbahnabschnitt an, in dem die Leiterbahnen 169, 181, 174 und 175 parallel zueinander ausgerichtet sind. An den zweiten Leiterbahnabschnitt schließt sich den Durchgangsbohrungen 60 bis 63 benachbart ein dritter Leiterbahnabschnitt an, in dem sich die jeweils ein Leiterpaar ausbildenden Leiterbahnen 169 und 181 bzw. 174 und 175 jeweils paarweise überdecken, wobei die unterschiedlichen Leiterpaare 169, 181 einerseits und 174, 175 andererseits einen deutlichen Abstand zueinander aufweisen.

Wie bereits unter Bezugnahme auf Figur 6 erläutert, wird durch die auf der Leiterplatte 119 angeordneten Kondensatorfelder 66, 67; 71, 72; 78, 79; 83, 84 jeweils ein Kompensationskondensator bereitgestellt, mit dessen Hilfe einer im Bereich der Kontaktfedern 37 auftretenden kapazitiven Kopplung zwischen Leitern unterschiedlicher Leiterpaare entgegengewirkt werden kann. Eine induktive Gegenkopplung zwischen dem ersten Leiterpaar, das den Durchgangsbohrungen 54, 55 zugeordnet ist, und dem zweiten Leiterpaar, das den Durchgangsbohrungen 53 und 56 zugeordnet ist, wird durch die Anordnung der Leiterbahnen 169, 181 und 174, 175 in deren ersten und zweiten Leiterbahnabschnitten erzielt, wie dies voranstehend bereits unter Bezugnahme auf die Leiterbahnen 69, 74, 75 und 81 erläutert wurde. Wiederum ist der Verlauf der Leiterbahnen derart gewählt, daß im ersten Leiterbahnabschnitt, d. h. im Bereich zwischen den Durchgangsbohrungen 53 bis 56 und dem Schnittpunkt S, der Abstand einer ersten Leiterbahn des ersten Leiterpaares 174, 175 zu einer ersten Leiterbahn des zweiten Leiterpaares 169, 181 geringer ist als der Abstand, den die jeweilige Leiterbahn im zweiten Leiterbahnabschnitt zur entsprechenden Leiterbahn des zweiten Leiterpaares aufweist. So ist im ersten Leiterbahnabschnitt der Abstand der Leiterbahn 174 zur Leiterbahn 169 geringer als zur Leiterbahn 181, während im zweiten Leiterbahnabschnitt der Abstand der Leiterbahn 174 zur Leiterbahn 181 geringer ist als zur Leiterbahn 169. Dies wird insbesondere aus Figur 7 deutlich. Entsprechendes gilt für die Leiterbahn 175, diese weist im ersten Leiterbahnabschnitt einen geringeren Abstand zur Leiterbahn 181 auf als zur Leiterbahn 169, während sie im zweiten Leiterbahnabschnitt einen geringeren Abstand zur Leiterbahn 169 als zur Leiterbahn 181 aufweist. Durch die somit erfolgende Umkehrung der Abstände, den die Leiterbahnen unterschiedlicher Leiterpaare in den ersten und zweiten Leiterbahnabschnitten aufweisen, wird eine effektive induktive Gegenkopplung erzielt, so daß insgesamt die Signalankopplung, die im Bereich der Kontaktfedern 37 unvermeidlich ist, wirkungsvoll kompensiert werden kann.

Wie aus Figur 7 deutlich wird, sind die Leiterbahnen 174, 175, 169 und 181 im Bereich des zweiten Leiterbahnabschnittes bezogen auf den Querschnitt der Leiterplatte 119 an den Eckpunkten eines Quadrates angeordnet. Der kürzeste Abstand einer Leiterbahn zu einer benachbarten Leiterbahn entspricht dadurch einer Seitenlänge des Quadrates. So ist beispielsweise der Abstand, den die Leiterbahn 175 im Bereich des zweiten Leiterbahnabschnittes zur Leiterbahn 169 aufweist, geringer als der Abstand, den die Leiterbahn 175 in diesem Bereich zur Leiterbahn 181 einnimmt. Dies wird aus Figur 7 unmittelbar deutlich. Es hat sich gezeigt, daß durch eine derartige Anordnung eine besonders geringe Signalankopplung sichergestellt werden kann.

Die Anschlüsse der Leiterplatte 119 sind mit den Anschlüssen der Leiterplatte 19 identisch. Somit kann das Kontaktmodul 17 wahlweise mit der Leiterplatte 19 oder mit der Leiterplatte 119 ausgestaltet werden.

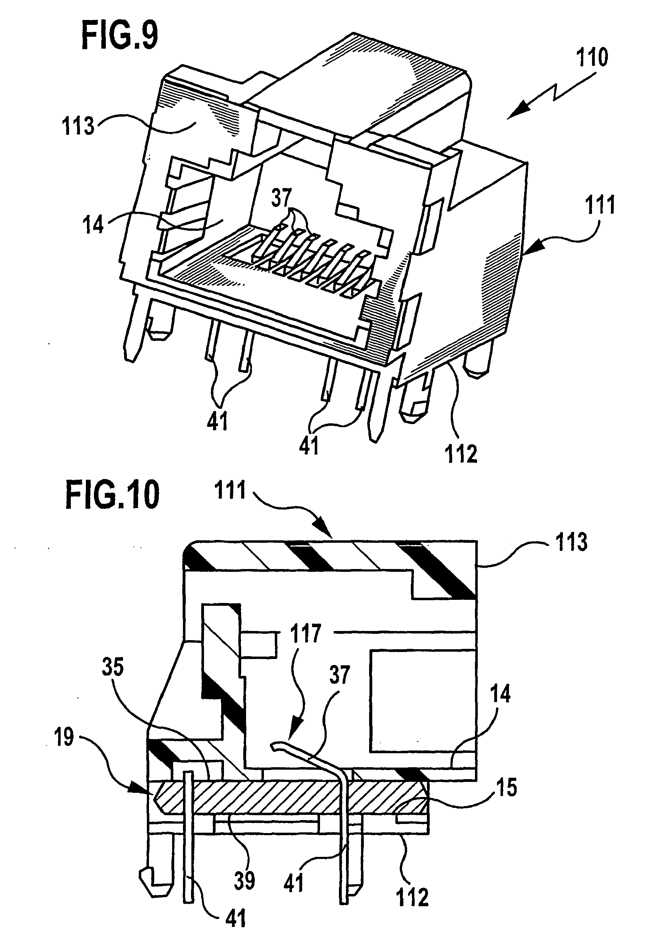

In den Figuren 9 und 10 ist schematisch eine weitere Ausführungsform einer erfindungsgemäßen Steckbuchse dargestellt, die insgesamt mit dem Bezugszeichen 110 belegt ist. Sie umfaßt ein Gehäuse 111, dessen Frontseite 113 senkrecht zu seiner Montageseite 112 ausgerichtet ist. Ansonsten weist die Steckbuchse 110 denselben Aufbau auf wie die voranstehend erläuterte Steckbuchse 10, so daß für identische Bauteile dieselben Bezugszeichen verwendet werden wie in den Figuren 1 bis 6. Zur Vermeidung von Wiederholungen wird diesbezüglich auf die voranstehenden Erläuterungen vollinhaltlich Bezug genommen.

Auch das Gehäuse 111 der Steckbuchse 110 weist montageseitig einen Montageschacht 15 auf, in den ein Kontaktmodul 117 eingesetzt ist. Dieses ist weitgehend identisch aufgebaut wie das bereits erläuterte Kontaktmodul 17 und unterscheidet sich von diesem lediglich dadurch, daß die unterseitig von der Leiterplatte 19 des Kontaktmodules 117 abstehenden Anschlußelemente in Form der Kontakte 41 senkrecht zur Unterseite der Leiterplatte 19 ausgerichtet sind, während sie beim Kontaktmodul 17 der Steckbuchse 10 unter einem Winkel von 45° zur Unterseite 39 ausgerichtet sind. Alternativ kann auch beim Kontaktmodul 117 statt der Leiterplatte 19 die Leiterplatte 119 zum Einsatz kommen.

Zur Fertigung der Steckbuchse 110 können also die selben Kontaktmodule 17 verwendet werden wie sie auch bei der Steckbuchse 10 zum Einsatz kommen, wobei lediglich ein letzter Montageschritt der Kontaktmodule 17, nämlich das Abschrägen der unterseitig von der Leiterplatte 19 bzw. 119 abstehenden Kontakte 41 entfällt, so daß diese also ihre beim Einpressen in die korrespondierenden Durchgangsbohrungen der Leiterplatte 19 bzw. 119 eingenommene Ausrichtung unverändert beibehalten. Die Herstellungskosten für die Steckbuchsen 10 und 110 können dadurch nicht unerheblich vermindert werden.

## Patentansprüche

1. Elektrische Steckbuchse mit einem Gehäuse (11; 111), das einen Steckerschacht (14) zum Einführen eines Verbindungssteckers aufweist und ein Kontaktmodul (17; 117) umgibt, wobei das Kontaktmodul (17; 117) mehrere elektrische Leiter umfaßt sowie Kontaktelemente, die von zugeordneten Steckkontakten des Verbindungssteckers kontaktierbar sind, wobei jeweils zwei Leiter ein Leiterpaar ausbilden zur Übertragung eines hochfrequenten elektrischen Signales und sich zumindest zwei Leiter überschneiden, wobei das Kontaktmodul (17; 117) eine mehrlagige elektrische Leiterplatte (19; 119) umfaßt und die Kontaktelemente in die Leiterplatte (19; 119) eingesetzt sind und mit ihren über die Leiterplatte (19; 119) überstehenden, dem Steckerschacht (14) zugewandten Endbereichen jeweils eine Kontaktfeder (37) ausbilden, und wobei die Leiterplatte (19; 119) Kompensationskondensatoren (66, 67; 71, 72; 78, 79; 88, 89) trägt zur kapazitiven Kopplung von Leitern unterschiedlicher Leiterpaare, und wobei die Leiterplatte (19; 119) Leiterbahnen (69, 74, 75, 81; 169, 174, 175, 181) trägt, die die elektrischen Leiter zumindest zweier Leiterpaare ausbilden, wobei in einem ersten Leiterbahnabschnitt eine erste Leiterbahn (74; 174) eines ersten Leiterpaares zu einer ersten Leiterbahn (69; 169) des zweiten Leiterpaares einen geringeren Abstand aufweist als zur zweiten Leiterbahn (81; 181) des zweiten Leiterpaares, während in einem zweiten Leiterbahnabschnitt die erste Leiterbahn (74; 174) des ersten Leiterpaares zur zweiten Leiterbahn (81; 181) des zweiten Leiterpaares einen geringeren Abstand aufweist als zur ersten Leiterbahn (69; 169) des zweiten Leiterpaares, **dadurch gekennzeichnet, daß** sich die Leiterbahnen (174, 175, 169, 181) des ersten und zweiten Leiterpaares in einem gemeinsamen Schnittpunkt (S) berührungslos überschneiden.

2. Elektrische Steckbuchse nach Anspruch 1, **dadurch gekennzeichnet, daß** sich der erste Leiterbahnabschnitt unmittelbar an die Kontaktfedern (37) anschließt.

3. Elektrische Steckbuchse nach Anspruch 1 oder 2, **dadurch gekennzeichnet, daß** der erste Leiterbahnabschnitt kürzer ist als der zweite Leiterbahnabschnitt.

4. Elektrische Steckbuchse nach Anspruch 1, 2 oder 3, **dadurch gekennzeichnet, daß** die Leiterbahnen (174, 175, 169, 181) des ersten und des zweiten Leiterpaares im zweiten Leiterbahnabschnitt bezogen auf den Querschnitt der Leiterplatte (119) an den Eckpunkten eines gleichseitigen Vierecks angeordnet sind.

5. Elektrische Steckbuchse nach einem der voranstehenden Ansprüche, **dadurch gekennzeichnet, daß** die Leiterplatte (119) vierlagig ausgestaltet ist, wobei die Leiterbahnen (174, 175, 169, 181) der ersten und zweiten Leiterpaare im zweiten Leiterbahnabschnitt jeweils in einer Ebene der Leiterplatte (119) verlaufen.

6. Elektrische Steckbuchse nach Anspruch 5, **dadurch gekennzeichnet, daß** die Leiterbahnen (174, 175, 169, 181) des ersten und zweiten Leiterpaares im zweiten Leiterbahnabschnitt bezogen auf den Querschnitt der Leiterplatte (119) an den Eckpunkten eines Quadrates angeordnet sind.

7. Elektrische Steckbuchse nach einem der voranstehenden Ansprüche, **dadurch gekennzeichnet, daß** sich die Leiterbahnen (74, 75; 174, 175, 169, 181) zumindest eines Leiterpaares zwischen dem ersten und zweiten Leiterbahnabschnitt berührungslos überschneiden.

8. Elektrische Steckbuchse nach einem der voranstehenden Ansprüche, **dadurch gekennzeichnet, daß** sich die Leiterbahnen (174, 175, 181, 169) unterschiedlicher Leiterpaare in einem einzigen Schnittpunkt berührungslos überschneiden.

9. Elektrische Steckbuchse nach einem der voranstehenden Ansprüche, **dadurch gekennzeichnet, daß** die Leiterbahnen (174, 175, 169, 181) in einem sich an den gemeinsamen Schnittpunkt (S) anschließenden Bereich parallel zueinander ausgerichtet sind.

10. Elektrische Steckbuchse nach einem der voranstehenden Ansprüche, **dadurch gekennzeichnet, daß** die Leiterbahnen (174, 175, 169, 181) des ersten und zweiten Leiterpaares spiegelsymmetrisch zueinander ausgerichtet sind.

11. Elektrische Steckbuchse nach einem der voranstehenden Ansprüche, **dadurch gekennzeichnet, daß** die Kontaktelemente in die Leiterplatte (19; 119) eingepresst sind.

12. Elektrische Steckbuchse nach einem der voranstehenden Ansprüche, **dadurch gekennzeichnet, daß** die Kontaktelemente die Leiterplatte (19; 119) durchgreifen.

13. Elektrische Steckbuchse nach einem der voranstehenden Ansprüche, **dadurch gekennzeichnet, daß** zumindest einige der Kontaktelemente aus Federstahl gefertigt sind.

14. Elektrische Steckbuchse nach einem der voranstehenden Ansprüche, **dadurch gekennzeichnet, daß** die Kompensationskondensatoren jeweils von zwei einander gegenüberliegenden, in unterschiedlichen Ebenen der Lei terplatte (19; 119) angeordneten, elektrisch leitfähigen Schichtbereichen (66, 67; 71, 72; 78, 79; 88, 89) ausgebildet sind.

15. Elektrische Steckbuchse nach einem der voranstehenden Ansprüche, **dadurch gekennzeichnet, daß** die Kompensationskondensatoren (66, 67; 71, 72; 78, 79; 88, 89) in dem den Kontaktfedern (37) unmittelbar benachbarten Bereich der Leiterplatte (19; 119) angeordnet sind.

16. Elektrische Steckbuchse nach einem der voranstehenden Ansprüche, **dadurch gekennzeichnet, daß** jedes Leiterpaar über mindestens einen Kompensationskondensator (66, 67; 71, 72; 78, 79; 88, 89) mit dem unmittelbar benachbart angeordneten Leiterpaar gekoppelt ist.

17. Elektrische Steckbuchse nach einem der voranstehenden Ansprüche, **dadurch gekennzeichnet, daß** die Leiterplatte (19) dreilagig ausgestaltet ist.

18. Elektrische Steckbuchse nach Anspruch 17, **dadurch gekennzeichnet, daß** die Leiterplatte (19) asymmetrisch ausgestaltet ist.

19. Elektrische Steckbuchse nach einem der voranstehenden Ansprüche, **dadurch gekennzeichnet, daß** die Leiterplatte (19; 119) auf ihrer dem Stekkerschacht (14) abgewandten Unterseite (39) mehrere Paare von Anschlußelementen trägt, die jeweils einem Leiterpaar zugeordnet sind, wobei die Paare von Anschlußelementen im Abstand zueinander angeordnet sind.

20. Elektrische Steckbuchse nach Anspruch 19, **dadurch gekennzeichnet, daß** die Anschlußelemente senkrecht zur Unterseite der Leiterplatte (19; 119) ausgerichtet sind.

21. Elektrische Steckbuchse nach Anspruch 19, **dadurch gekennzeichnet, daß** die Anschlußelemente schräg zur Unterseite der Leiterplatte (19; 119) ausgerichtet sind.

22. Elektrische Steckbuchse nach Anspruch 19, 20 oder 21, **dadurch gekennzeichnet, daß** die Anschlußelemente in die Leiterplatte (19; 119) eingesetzt sind.

23. Elektrische Steckbuchse nach einem der Ansprüche 19 bis 22, **dadurch gekennzeichnet, daß** die Anschlußelemente und die Kontaktelemente als in die Leiterplatte (19; 119) eingepresste Kontaktstifte (20-33) ausgebildet sind, wobei einige Kontaktstifte (21-28) über die dem Steckerschacht (14) zugewandte Oberseite überstehen und die Kontaktfedern (37) ausbilden und wobei einige Kontaktstifte (20, 22, 27, 29, 30-33) über die dem Steckerschacht (14) abgewandte Unterseite (39) der Leiterplatte (19; 119) überstehen und Kontakte (41) zum Anschluß von Verbindungselementen ausbilden.

24. Elektrische Steckbuchse nach Anspruch 23, **dadurch gekennzeichnet, daß** die über die Oberseite (35) der Leiterplatte (19; 119) überstehenden Kontaktstifte (21-28) eine Kontaktanordnung mit acht nebeneinander angeordneten Kontaktfedern (37) ausbilden.

25. Elektrische Steckbuchse nach Anspruch 23 oder 24, **dadurch gekennzeichnet, daß** die über die Unterseite (39) der Leiterplatte (19; 119) überstehenden Kontaktstifte (20, 22, 27, 29, 30-33) eine Anschlußanordnung ausbilden mit vier zueinander beabstandeten Paaren von Kontakten (41).

## Claims

1. Electrical socket with a housing (11; 111), which has a compartment (14) for inserting a connector and surrounds a contact module (17; 117), the contact module (17; 117) comprising a number of electrical conductors and contact elements which can be contacted by associated plug contacts of the connector, two conductors respectively forming a pair of conductors for the transmission of a high-frequency electrical signal and at least two conductors intersecting, the contact module (17; 117) comprising a multi-layer electrical circuit board (19; 119), and the contact elements being inserted into the circuit board (19; 119) and respectively forming a contact spring (37) by their end regions projecting beyond the circuit board (19; 119) and facing toward the compartment (14) for the connector, and the circuit board (19; 119) carrying compensation capacitors (66, 67; 71, 72; 78, 79; 88, 89) for the capacitive coupling of conductors of different pairs of conductors, and the circuit board (19; 119) carrying conductor tracks (69, 74, 75, 81; 169, 174, 175, 181) which form the electrical conductors of at least two pairs of conductors in such a way that, in a first conductor track section, a first conductor track (74; 174) of a first pair of conductors is at a smaller distance from a first conductor track (69; 169) of the second pair of conductors than from the second conductor track (81; 181) of the second pair of conductors, whereas, in a second conductor track section, the first conductor track (74; 174) of the first pair of conductors is at a smaller distance from the second conductor track (81; 181) of the second pair of conductors than from the first conductor track (69; 169) of the second pair of conductors, **characterized in that** the conductor tracks (174, 175, 169, 181) of the first and second pairs of conductors intersect contactlessly at a common point of intersection (S).

2. Electrical socket according to Claim 1, **characterized in that** the first conductor track section follows on directly from the contact springs (37).

3. Electrical socket according to Claim 1 or 2, **characterized in that** the first conductor track section is shorter than the second conductor track section.

4. Electrical socket according to Claim 1, 2 or 3, **characterized in that** the conductor tracks (174, 175, 169, 181) of the first and second pairs of conductors in the second conductor track section are disposed at the corner points of an equal-sided quadrangle with respect to the cross-section of the circuit board (119).

5. Electrical socket according to one of the preceding claims, **characterized in that** the circuit board (119) is of a four-layer configuration, and the conductor tracks (174, 175, 169, 181) of the first and second pairs of conductors in the second conductor track section respectively run in one plane of the circuit board (119).

6. Electrical socket according to Claim 5, **characterized in that** the conductor tracks (174, 175, 169, 181) of the first and second pairs of conductors in the second conductor track section are disposed at the corner points of a square with respect to the cross-section of the circuit board (119).

7. Electrical socket according to one of the preceding claims, **characterized in that** the conductor tracks (74, 75; 174, 175, 169, 181) of at least one pair of conductors intersect contactlessly between the first and second conductor track sections.

8. Electrical socket according to one of the preceding claims, **characterized in that** the conductor tracks (174, 175, 169, 181) of different pairs of conductors intersect contactlessly at a single point of intersection.

9. Electrical socket according to one of the preceding claims, **characterized in that** the conductor tracks (174, 175, 169, 181) are aligned parallel to one another in a region following on from the common point of intersection (S).

10. Electrical socket according to one of the preceding claims, **characterized in that** the conductor tracks (174, 175, 169, 181) of the first and second pairs of conductors are aligned mirror-symmetrically in relation to one another.

11. Electrical socket according to one of the preceding claims, **characterized in that** the contact elements are pressed into the circuit board (19; 119).

12. Electrical socket according to one of the preceding claims, **characterized in that** the contact elements reach through the circuit board (19; 119).

13. Electrical socket according to one of the preceding claims, **characterized in that** at least some of the contact elements are produced from spring steel.

14. Electrical socket according to one of the preceding claims, **characterized in that** the compensation capacitors are respectively formed by two electrically conductive layer regions (66, 67; 71, 72; 78, 79; 88, 89) lying opposite each other, disposed in different planes of the circuit board (19; 119).

15. Electrical socket according to one of the preceding claims, **characterized in that** the compensation capacitors (66, 67; 71, 72; 78, 79; 88, 89) are disposed in the region of the circuit board (19; 119) directly adjacent the contact springs (37).

16. Electrical socket according to one of the preceding claims, **characterized in that** each pair of conductors is coupled to the directly adjacent pair of conductors by means of at least one compensation capacitor (66, 67; 71, 72; 78, 79; 88, 89).

17. Electrical socket according to one of the preceding claims, **characterized in that** the circuit board (19) is of a three-layer configuration.

18. Electrical socket according to Claim 17, **characterized in that** the circuit board (19) is asymmetrically configured.

19. Electrical socket according to one of the preceding claims, **characterized in that** the circuit board (19; 119) carries on its underside (39), facing away from the compartment (14) for the connector, a number of pairs of terminal elements, which are respectively associated with a pair of conductors, and the pairs of terminal elements are disposed at a distance from one another.

20. Electrical socket according to Claim 19, **characterized in that** the terminal elements are aligned perpendicularly in relation to the underside of the circuit board (19; 119).

21. Electrical socket according to Claim 19, **characterized in that** the terminal elements are aligned obliquely in relation to the underside of the circuit board (19; 119).

22. Electrical socket according to Claim 19, 20 or 21, **characterized in that** the terminal elements are inserted into the circuit board (19; 119).

23. Electrical socket according to one of Claims 19 to 22, **characterized in that** the terminal elements and the contact elements are formed as contact pins (20-33) pressed into the circuit board (19; 119), some contact pins (21-28) projecting beyond the upper side, facing toward the compartment (14) for the connector, and forming the contact springs (37), and some contact pins (20, 22, 27, 29, 30-33) projecting beyond the underside (39) of the circuit board (19; 119), facing away from the compartment (14) for the connector, and forming contacts (41) for the connection of connecting elements.

24. Electrical socket according to Claim 23, **characterized in that** the contact pins (21-28) projecting beyond the upper side (35) of the circuit board (19; 119) form a contact configuration with eight contact springs (37) disposed next to one another.

25. Electrical socket according to Claim 23 or 24, **characterized in that** the contact pins (20, 22, 27, 29, 30-33) projecting beyond the underside (39) of the circuit board (19; 119) form a terminal configuration with four spaced-apart pairs of contacts (41).

## Revendications

1. Fiche électrique femelle comprenant un boîtier (11 ; 111) qui comporte une cavité de connecteur mâle (14), destinée à l'insertion d'une fiche de connexion, et un module de contact (17 ; 117), ledit module de contact (17 ; 117) comportant plusieurs conducteurs électriques ainsi que des éléments de contact avec lesquels peuvent être en contact des contacts enfichables associés de la fiche de connexion, deux conducteurs formant à chaque fois une paire de conducteurs pour la transmission d'un signal électrique à haute fréquence et au moins deux conducteurs se croisant, le module de contact (17 ; 117) comportant une carte de circuits imprimés électrique multicouches (19 ; 119), et les éléments de contact étant insérés dans la carte de circuits imprimés (19 ; 119) en formant chacun un ressort de contact (37) au niveau de leur région d'extrémité dirigée vers la cavité de connecteur mâle (14) et en saillant au-dessus de la carte de circuits imprimés (19 ; 119), la carte de circuits imprimés (19 ; 119) supportant des condensateurs de compensation (66, 67 ; 71, 72 ; 78, 79 ; 88, 89) pour le couplage capacitif de conducteurs de différentes paires de conducteurs, et la carte de circuits imprimés (19 ; 119) supportant des pistes conductrices (69, 74, 75, 81 ; 169, 174, 175, 181) qui forment les conducteurs électriques d'au moins deux paires de conducteurs, où, dans une première portion de pistes conductrices, une première piste conductrice (74 ; 174) d'une première paire de conducteurs étant moins distante d'une première piste conductrice (69 ; 169) de la deuxième paire de conducteurs que de la deuxième piste conductrice (81 ; 181) de la deuxième paire de conducteurs, tandis que, dans une deuxième portion de pistes conductrices, la première piste conductrice (74 ; 174) de la première paire de conducteurs étant moins distante de la deuxième piste conductrice (81 ; 181) de la deuxième paire de conducteurs que de la première piste conductrice (69 ; 169) de la deuxième paire de conducteurs, **caractérisée en ce que** les pistes conductrices (174, 175, 169, 181) des première et deuxième paires de conducteurs se croisent sans contact en un point d'intersection commun (S).

2. Fiche électrique femelle selon la revendication 1, **caractérisée en ce que** la première portion de pistes électriques se raccorde directement aux ressorts de contact (37).

3. Fiche électrique femelle selon la revendication 1 ou 2, **caractérisée en ce que** la première portion de pistes conductrices est plus courte que la deuxième portion de pistes conductrices.

4. Fiche électrique femelle selon la revendication 1, 2 ou 3, **caractérisée en ce que** les pistes conductrices (174, 175, 169, 181) des première et deuxième paires de conducteurs, dans la deuxième portion de pistes conductrices, sont disposées aux coins d'un rectangle formé par la carte de circuits imprimés (119) lorsqu'elle est vue en coupe transversale.

5. Fiche électrique femelle selon l'une des revendications précédentes, **caractérisée en ce que** la carte de circuits imprimés (119) est conformée avec quatre couches, les pistes conductrices (174, 175, 169, 181) des première et deuxième paires de conducteurs, dans la deuxième portion de pistes conductrices, s'étendant chacune dans un plan de la carte de circuits imprimés (119).

6. Fiche électrique femelle selon la revendication 5, **caractérisée en ce que** les pistes conductrices (174, 175, 169, 181) des première et deuxième paires de conducteurs, dans la deuxième portion de pistes conductrices, sont disposées aux coins d'un carré formé par la carte de circuits imprimés (119) lorsqu'elle est vue en coupe transversale.

7. Fiche électrique femelle selon l'une des revendications précédentes, **caractérisée en ce que** les pistes conductrices (74, 75 ; 174, 175, 169, 181) d'au moins une paire de conducteurs se croisent sans contact entre les première et deuxième portions de pistes conductrices.

8. Fiche électrique femelle selon l'une des revendications précédentes, **caractérisée en ce que** les pistes conductrices (174, 175, 181, 169) de différentes paires de conducteurs se croisent sans contact en un point d'intersection unique.

9. Fiche électrique femelle selon l'une des revendications précédentes, **caractérisée en ce que** les pistes conductrices (174, 175, 169, 181), se trouvant dans une région se raccordant au point d'intersection commun (S), sont orientées parallèlement l'une à l'autre.

10. Fiche électrique femelle selon l'une des revendications précédentes, **caractérisée en ce que** les pistes conductrices (174, 175, 169, 181) des première et deuxième paires de conducteurs sont orientées symétriquement l'une par rapport à l'autre.

11. Fiche électrique femelle selon l'une des revendications précédentes, **caractérisée en ce que** les éléments de contact sont enfoncés dans la carte de circuits imprimés (19 ; 119).

12. Fiche électrique femelle selon l'une des revendications précédentes, **caractérisée en ce que** les éléments de contact sont accrochés à travers la carte de circuits imprimés (19 ; 119).

13. Fiche électrique femelle selon l'une des revendications précédentes, **caractérisée en ce qu'**au moins un certain nombre des éléments de contact sont fabriqués à partir d'acier à ressort.

14. Fiche électrique femelle selon l'une des revendications précédentes, **caractérisée en ce que** les condensateurs de compensation sont formés chacun par deux zones de couche opposées (66, 67 ; 71, 72 ; 78, 79 ; 88, 89) électriquement conductrices et disposées dans des plans différents de la carte de circuits imprimés (19 ; 119).

15. Fiche électrique femelle selon l'une des revendications précédentes, **caractérisée en ce que** les condensateurs de compensation (66, 67 ; 71, 72 ; 78, 79 ; 88, 89) sont disposés dans la zone de la carte de circuits imprimés (19 ; 119) qui est immédiatement adjacente aux ressorts de contact (37).

16. Fiche électrique femelle selon l'une des revendications précédentes, **caractérisée en ce que** chaque paire de conducteurs est couplée à la paire de conducteurs immédiatement adjacente par l'intermédiaire d'au moins un condensateur de compensation (66, 67 ; 71, 72 ; 78, 79 ; 88, 89).

17. Fiche électrique femelle selon l'une des revendications précédentes, **caractérisée en ce que** la carte de circuits imprimés (19) est conformée avec trois couches.

18. Fiche électrique femelle selon la revendication 17, **caractérisée en ce que** la carte de circuits imprimés (19) a une conformation asymétrique.

19. Fiche électrique femelle selon l'une des revendications précédentes, **caractérisée en ce que** la carte de circuits imprimés (19 ; 119) supporte sur son côté inférieur (39), qui est opposé à la cavité de connecteur mâle (14), plusieurs paires d'éléments de raccordement qui sont associées chacune à une paire de conducteurs, les paires d'éléments de raccordement étant placées à distance l'une de l'autre.

20. Fiche électrique femelle selon la revendication 19, **caractérisée en ce que** les éléments de raccordement sont orientés perpendiculairement au côté inférieur de la carte de circuits imprimés (19 ; 119).

21. Fiche électrique femelle selon la revendication 19, **caractérisée en ce que** les éléments de raccordement sont orientés obliquement par rapport au côté inférieur de la carte de circuits imprimés (19 ; 119).

22. Fiche électrique femelle selon la revendication 19, 20 ou 21, **caractérisée en ce que** les éléments de raccordement sont insérés dans la carte de circuits imprimés (19 ; 119).

23. Fiche électrique femelle selon l'une des revendications 19 à 22, **caractérisée en ce que** les éléments de raccordement et les éléments de contact sont conformés en picots de contact (20-33) enfoncés dans la carte de circuits imprimés (19 ; 119), certains des picots de contact (21-28) saillant du côté supérieur qui est dirigé vers la cavité de connecteur mâle (14) et formant les ressorts de contact (37), et certains des picots de contact (20, 22, 27, 29, 30 - 33) saillant du côté inférieur (39) de la carte de circuits imprimés qui est opposé à la cavité de connecteur mâle (14) et formant des contacts (41) destinés au raccordement des éléments de raccordement.

24. Fiche électrique femelle selon la revendication 23, **caractérisée en ce que** les picots de contact (21-28), saillant du côté supérieur (35) de la carte de circuits imprimés (19 ; 119), forment un agencement de contact à huit ressorts de contact (37) disposés l'un à côté de l'autre.

25. Fiche électrique femelle selon la revendication 23 ou 24, **caractérisée en ce que** les picots de contact (20, 22, 27, 29, 30-33), saillant du côté inférieur (39) de la carte de circuits imprimés (19 ; 119), forment un agencement de raccordement à quatre paires de contact (41) distantes l'une de l'autre.
